(19) Europäisches Patentamt
European Patent Office
Office européen des brevets

(11) **EP 3 667 351 B1**

(12) **EUROPÄISCHE PATENTSCHRIFT**

(45) Veröffentlichungstag und Bekanntmachung des Hinweises auf die Patenterteilung:
**26.01.2022  Patentblatt 2022/04**

(21) Anmeldenummer: **19214146.3**

(22) Anmeldetag: **06.12.2019**

(51) Internationale Patentklassifikation (IPC):
***G01R 33/3875*** (2006.01)    *G01R 33/3815* (2006.01)

(52) Gemeinsame Patentklassifikation (CPC):
**G01R 33/3875;** G01R 33/3815

(54) **VERFAHREN ZUM LADEN EINER HTS-SHIM-VORRICHTUNG**

METHOD FOR CHARGING AN HTS SHIM DEVICE

PROCÉDÉ DE CHARGE D'UN DISPOSITIF DE SHIM-HTS

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **10.12.2018  DE 102018221322**

(43) Veröffentlichungstag der Anmeldung:
**17.06.2020  Patentblatt 2020/25**

(73) Patentinhaber: **Bruker Switzerland AG 8117 Fällanden (CH)**

(72) Erfinder:
• **Günter, Kenneth J.
8002 Zürich (CH)**
• **Schauwecker, Robert
8004 Zürich (CH)**

(74) Vertreter: **Kohler Schmid Möbus Patentanwälte Partnerschaftsgesellschaft mbB Gropiusplatz 10 70563 Stuttgart (DE)**

(56) Entgegenhaltungen:
**DE-A1-102016 225 017     US-A- 6 014 069**

• **DONGKEUN PARK ET AL: "HTS Shim Coils Energized by a Flux Pump for the MIT 1.3-GHz LTS/HTS NMR Magnet: Design, Construction, and Results of a Proof-of-Concept Prototype", IEEE TRANSACTIONS ON APPLIED SUPERCONDUCTIVITY., Bd. 28, Nr. 3, 30. Januar 2018 (2018-01-30), Seiten 1-5, XP055687332, US ISSN: 1051-8223, DOI: 10.1109/TASC.2018.2799182**

**Beschreibung**

Hintergrund der Erfindung

Die Erfindung betrifft ein Verfahren zum Laden einer HTS(=Hochtemperatursupraleiter)-Shim-Vorrichtung eines in einem Kryostaten mit einer Raumtemperaturbohrung angeordneten supraleitenden Magnetspulensystems mittels einer Ladevorrichtung, wobei die HTS-Shim-Vorrichtung eine supraleitend geschlossene HTS-Shim-Leiterbahn und einen Shim-Schalter zur zeitweisen Unterbrechung des supraleitenden Zustandes in einem Abschnitt der HTS-Shim-Leiterbahn umfasst.

Eine HTS-Shim-Vorrichtung und ein Verfahren zum Laden der HTS-Shim-Vorrichtung sind in [03] beschrieben.

Supraleitend geschlossene HTS-Spulen sind beispielsweise bekannt aus [01], [02], [03] und [09] und können in Magnetspulensystemen als Hauptmagnet oder Teile davon zum Erzeugen des Hauptmagnetfeldes eingesetzt werden.

Zum Laden von supraleitenden Spulen, die als Hauptmagnete in einem Magnetspulensystem eingesetzt werden, sind unterschiedliche Ladeverfahren bekannt. Gemäß [05], [06], [07], [08] und [10] können zum Laden von Hauptmagneten bspw. Flusspumpen eingesetzt werden. Durch die Verwendung einer Flusspumpe wird der Ladevorgang auf mehrere Zyklen aufgeteilt. Dies ist jedoch mit einer hohen Ladedauer verbunden.

[12] offenbart ein Ladeverfahren für einen MRI-Hauptmagneten, bei dem ein Primärstromkreis eine erste Spule umfasst, deren Stromversorgung parallel zu einem ersten Schalter angeschlossen ist. Parallel zu der ersten Spule ist eine zweite Spule geschaltet, die über einen zweiten Schalter zugeschaltet werden kann. Die erste Spule kann bei einer Ausführungsform im Kryostaten angeordnet sein. Die zweite Spule ist immer außerhalb des Kryostaten, also in einem Raumtemperaturbereich, angeordnet und ist mit der Hauptspule induktiv gekoppelt. Jedoch kann auch nach Durchlaufen mehrerer Laderampen mit dem in [12] beschriebenen Verfahren kein nennenswerter Stromanstieg im Hauptmagneten erreicht werden.

Aus [13] ist eine Magnetanordnung mit einem Hauptmagneten bekannt, der sowohl LTS(=Tieftemperatursupraleiter)-Spulen als auch eine HTS-Spule aufweist, wobei die HTS-Spule durch induktive Kopplung mit den LTS-Spulen geladen wird.

[14] offenbart eine Korrekturspulenschaltung für einen supraleitenden MRI-Magneten zum selektiven Schalten verschiedener Spulen in einem Stromkreis. Durch eine induktive Kopplung einer Spule außerhalb des Magneten mit der Korrekturspule können zusätzliche mechanische Leitungen vermieden werden. HTS-Spulen werden insbesondere auch als Shim-Spulen zum Homogenisieren des Hauptmagnetfeldes eingesetzt, da Shim-Spulen aus HTS-Material die Feldhomogenität von HTS-Hauptmagneten verbessern können, deren Betriebsfelder oder - temperaturen den Einsatz von LTS-Material für Shim-Spulen nicht erlauben. Insbesondere supraleitend geschlossene Shim-Spulen aus HTS-beschichteten Leiterbahnen [01], [02], [03] haben den Vorteil, dass sie persistente Ströme tragen können, d.h. es ist kein Netzgerät zum Aufrechterhalten der elektrischen Ströme notwendig. Das Laden dieser Spulen erfolgt über einen direkten Anschluss an ein Netzgerät. Dazu wird der supraleitende Shim-Stromkreislauf unterbrochen, indem ein supraleitender Schalter geöffnet wird. Der Strom wird mit dem Netzgerät, welches parallel zum supraleitenden Schalter angeschlossen ist, direkt in den Shim-Stromkreislauf eingefahren. Nach Schließen des supraleitenden Schalters fließt der Strom im Shim-Stromkreislauf persistent und der Strom des Netzgeräts wird heruntergefahren. Persistente Shim-Spulen aus HTS-beschichteten Leiterbahnen erfordern aufgrund ihrer geringen Induktivität typischerweise deutlich größere elektrische Ströme zur Erzeugung einer gewissen Feldstärke als gewickelte Shim-Spulen mit mehreren Windungen. Das aus [03] bekannte Ladeverfahren hat daher den Nachteil, dass die entsprechend groß dimensionierten Stromzuleitungen viel Wärme von außen in den Kryostaten leiten. Außerdem erzeugen die hohen Ströme in den zumindest teilweise normalleitenden Zuleitungen während des Ladevorgangs zusätzliche Joulesche Wärme. Bei einem badgekühlten Kryostaten führt dies zu einer schnelleren Evaporation des Kryogenbades. Bei einem aktiv gekühlten Kryostaten muss ein Kryokühler mit entsprechend höherer Kühlleistung eingesetzt werden.

[11] offenbart eine Anordnung mit einer Shim-Spule, welche induktiv vom Hauptmagneten geladen wird, sodass der Wärmeeintrag über Stromzuleitungen wegfällt.

Aufgrund der speziellen Topologie der HTS-beschichteten Leiterbahnen (im Gegensatz zu aus Drähten gewickelten Shim-Spulen) ist eine gute induktive Entkopplung zwischen mehreren solchen Leiterbahnen praktisch unmöglich, weshalb sich das Laden mehrerer Shim-Spulen schwierig gestaltet. In [04] werden eine supraleitende Magnetanordnung und ein Ladeverfahren offenbart, welche ein gleichzeitiges Laden induktiv gekoppelter Shim-Spulen über eine gemeinsame Stromzuleitung ermöglichen. Die elektrische Schaltung erfordert jedoch spezielle, tieftemperaturtaugliche Halbleiterschalter (z.B. MOSFETs) sowie zusätzliche Messwiderstände zur Regelung der Endströme. Die Verdrahtung durch die zusätzlichen Signal- und Steuerkabel und die Steuerung der Shim-Spulen sind recht aufwändig. Außerdem ist eine zeitlich exakte Umschaltung der supraleitenden Schalter, welche für eine präzise Stromeinstellung nötig ist, sehr schwierig zu bewerkstelligen.

## Aufgabe der Erfindung

Es ist daher Aufgabe der Erfindung, ein Verfahren zum Laden von persistenten HTS-Shims vorzuschlagen, bei dem der Wärmeeintrag in den Kryostaten unterbunden werden kann und mit wenig materiellem Aufwand ein effektives Laden der HTS-Shim-Leiterbahnen mit bestimmten elektrischen Sollströmen ermöglicht wird. Darüber hinaus soll eine Magnetanordnung mit einer Ladevorrichtung vorgeschlagen werden, mit welcher die HTS-Shim-Vorrichtung entsprechend geladen werden kann.

## Beschreibung der Erfindung

Diese Aufgabe wird erfindungsgemäß gelöst durch ein Verfahren gemäß Anspruch 1.

Erfindungsgemäß umfasst die Ladevorrichtung eine normalleitende Ladespule, mindestens eine Energieversorgung und Zuleitungen und bildet mindestens einen Primärstromkreis. Die HTS-Shim-Vorrichtung umfasst eine HTS-Shim-Leiterbahn und einen Shim-Schalter und bildet einen Sekundärstromkreis. Im Sekundärstromkreis erfolgt eine Änderung des elektrischen Stroms (Sekundärstromänderung) induktiv mittels einer Änderung des von der Ladespule erzeugten magnetischen Flusses durch die von der HTS-Shim Leiterbahn eingeschlossene Fläche, wobei in einer ersten Phase in beliebiger Reihenfolge der Shim-Schalter zur Unterbrechung des supraleitenden Zustandes in einem Abschnitt der HTS-Shim-Leiterbahn mindestens zeitweise geöffnet wird, die Ladespule in die Raumtemperaturbohrung des Kryostaten positioniert wird und zumindest eine Änderung des elektrischen Stroms im Primärstromkreis vorgenommen wird. In einer zweiten Phase wird die HTS-Shim-Leiterbahn durch Schließen des Shim-Schalters supraleitend geschlossen. In einer dritten Phase wird bei geschlossenem Shim-Schalter der elektrische Strom im Primärstromkreis verändert und/oder die Ladespule aus der Raumtemperaturbohrung entfernt. Die Änderungen des elektrischen Stroms im Primärstromkreis in der ersten und dritten Phase werden im Folgenden Primärstromanpassungen genannt. Durch das Verfahren überlagert sich das Magnetfeld der derart geladenen HTS-Shim-Vorrichtung dem Magnetfeld eines Hauptmagneten des Magnetspulensystems, derart, dass der räumliche Verlauf und/oder die räumliche Homogenität des vom Magnetspulensystem in einem Arbeitsvolumen erzeugten Magnetfeldes eingestellt wird.

Gemäß dem erfindungsgemäßen Verfahren wird die HTS-Shim-Vorrichtung induktiv geladen. Dazu wird eine normalleitende Ladespule verwendet, die in der Raumtemperaturbohrung des Kryostaten angeordnet ist. Dadurch wird - abgesehen von der Wärme des Shim-Schalters - ein Wärmeeintrag in den Kryostaten verhindert. Die Ladespule wird von einer Energieversorgung gespeist, die sich außerhalb des Kryostaten befindet. Das Positionieren der Ladespule in der Raumtemperaturbohrung erfolgt vorzugsweise durch Einführen der Ladespule in die Raumtemperaturbohrung im Rahmen der ersten Phase oder dadurch, dass die Ladespule bei einem vorherigen Ladevorgang nicht aus der Raumtemperaturbohrung entfernt wurde.

Beim Öffnen des Shim-Schalters bleibt der jeweilige Sekundärstromkreis zwar elektrisch kurzgeschlossen, wird im Bereich des Shim-Schalters jedoch normalleitend bzw. resistiv. Dies kann beispielsweise durch eine Temperaturbeaufschlagung im Bereich des Shim-Schalters erfolgen. Alternativ oder zusätzlich kann der supraleitende Sekundärstromkreis auch unterbrochen werden, indem im Bereich des Shim-Schalters ein starkes Magnetfeld oder ein elektromagnetisches Wechselfeld erzeugt wird. Bei geschlossenem Shim-Schalter ist der Sekundärstromkreis supraleitend geschlossen.

Das Einspeisen des Stroms in den Sekundärstromkreis, also der eigentliche Ladevorgang, findet in der dritten Phase bei geschlossenem Shim-Schalter statt. Dabei wird der Strom im Sekundärstromkreis induktiv als Folge einer Änderung des von der Ladespule erzeugten magnetischen Flusses durch die von der HTS-Shim-Leiterbahn eingeschlossene Fläche eingestellt.

Die erste Phase dient dazu, den magnetischen Fluss, welcher nach der zweiten bzw. vor der dritten Phase die von der supraleitend geschlossenen HTS-Shim-Leiterbahn eingeschlossene Fläche durchdringt, anzupassen. Dieser magnetische Fluss ist gegeben durch das Produkt der Gegeninduktivität zwischen Ladespule und HTS-Shim-Leiterbahn und dem in der Ladespule fließenden elektrischen Strom (Primärstrom). So kann beispielsweise mit einer Primärstromanpassung in der ersten Phase der magnetische Fluss auf denjenigen Wert eingestellt werden, welcher bei einem kompletten Entfernen dieses Flusses (durch komplettes Entladen und/oder Entfernen der Ladespule aus der Raumtemperaturbohrung) bei geschlossenem Shim-Schalter in der dritten Phase gerade zur Induktion des gewünschten Sollstroms in der HTS-Shim-Leiterbahn führt. Gegebenenfalls kann in der ersten Phase zusätzlich eine Primärstromanpassung zum kontrollierten Entladen des Sekundärstromkreises (s.u.) vorgenommen werden.

Die elektrischen Sollströme, welche in den Shim-Spulen fließen müssen, um im Arbeitsvolumen eines Magnetspulensystems eine gewünschte Magnetfeldverteilung zu erreichen, werden üblicherweise wie folgt ermittelt. Mit einem Magnetfeldsensor (z.B. Hall-Sensor oder NMR-Probe) wird zuerst das vom Hauptmagneten erzeugte Magnetfeld im Arbeitsvolumen ausgemessen. Dann wird aufgrund der Geometrie der Shim-Spulen berechnet, mit welchen elektrischen Strömen die verschiedenen Shim-Spulen ein Magnetfeld erzeugen, welches das gemessene Magnetfeld im Arbeitsvolumen wunschgemäß anpasst bzw. korrigiert.

**EP 3 667 351 B1**

Vorzugsweise wird in der dritten Phase der Primärstrom auf 0 heruntergefahren und/oder die Ladespule vollständig aus der Raumtemperaturbohrung entfernt.

Vorzugsweise wird in der ersten Phase der Shim-Schalter geöffnet, bevor eine Änderung des magnetischen Flusses am Ort des Sekundärstromkreises bewirkt wird (durch Einbringen der bestromten (mit Strom durchflossenen) Ladespule in die Raumtemperaturbohrung oder durch Einstellen (Verändern) des elektrischen Stroms im Primärstromkreis). Auf diese Weise wird vermieden, dass in der ersten Phase bereits Strom in den Sekundärstromkreis induziert wird, welcher beim Öffnen des Shim-Schalters zu einer Wärmedissipation führen würde.

Normalerweise gibt es mehrere Möglichkeiten, die Ladespule axial in der Raumtemperaturbohrung zu positionieren und eine genügend starke induktive Kopplung mit der HTS-Shim-Leiterbahn zu erreichen. Vorzugsweise wird eine Position gewählt, bei der die Polarität des Primärstroms in der Ladespule während dem Ladeverfahren mehrheitlich so ist, dass das magnetische Streufeld der Ladespule dem Magnetfeld am Ort der Spulen des Hauptmagneten entgegengesetzt ist. Dadurch wird sichergestellt, dass der supraleitende Hauptmagnet während dem Laden der HTS-Shim-Vorrichtung nicht kritischer wird, d.h. seine supraleitende Stromtragfähigkeit nicht reduziert wird.

Vorzugsweise wird die Ladespule nach dem Ladevorgang wieder aus der Raumtemperaturbohrung entfernt, so dass der Platz für andere Komponenten zur Verfügung steht, die für die in der Vorrichtung auszuführenden Messungen benötigt werden, wie z.B. Raumtemperatur-Shims oder ein Probenkopf.

Bei einer bevorzugten Variante des erfindungsgemäßen Verfahrens wird zum Einstellen des elektrischen Stroms im Primärstromkreis in der ersten Phase der Strom im Primärstromkreis hochgefahren, und zum Anpassen des elektrischen Stroms im Primärstromkreis in der dritten Phase der Strom im Primärstromkreis heruntergefahren. Vorteilhaft ist diese Variante insbesondere dann, wenn der Primärstrom in der ersten Phase von 0 A hochgefahren und in der dritten Phase auf 0 A heruntergefahren wird, so dass die Ladespule nach dem Ladevorgang stromlos und keine Speisung durch eine Energieversorgung mehr erforderlich ist.

Besonders vorteilhaft ist es, wenn zum Entladen des Sekundärstromkreises in der ersten Phase bei supraleitend geschlossenem Sekundärstromkreis der Strom in der Ladespule so eingestellt wird, dass der Strom im Sekundärstromkreis auf 0 abfällt. Die vorgängige vollständige Entladung der HTS-Shim-Leiterbahn ist vorteilhaft, da ansonsten die in der HTS-Shim-Leiterbahn gespeicherte Energie über den elektrischen Widerstand des später geöffneten Shim-Schalters als Wärme dissipiert würde.

Vorzugsweise bildet dieser Entladevorgang die einzige Primärstromanpassung in der ersten Phase, bei der der Shim-Schalter geschlossen ist.

Bei einer speziellen Variante des erfindungsgemäßen Verfahrens erfolgt in der ersten Phase zumindest eine der Änderungen des elektrischen Stromes im Primärstromkreis nach Öffnen des Shim-Schalters. Das Laden des Sekundärstromkreises kann dann in der dritten Phase durch eine Primärstromanpassung mit entgegengesetzten Vorzeichen erfolgen, insbesondere durch Herunterfahren des Primärstroms auf 0 oder durch Entfernen der bestromten (mit Strom durchflossenen) Ladespule aus der Raumtemperaturbohrung.

Erfindungsgemäß umfasst die HTS-Shim-Vorrichtung n>1 HTS-Shim-Leiterbahnen, die je mit einem Shim-Schalter je einen Sekundärstromkreis bilden, wobei die HTS-Shim-Leiterbahnen der Sekundärstromkreise induktiv miteinander gekoppelt sind.

Zunächst wird eine Abfolge von Schalteröffnungen und Schalterschließungen der Shim-Schalter der Sekundärstromkreise und eine Abfolge von Änderungen des elektrischen Stroms im Primärstromkreis festgelegt. Dabei wird nach jedem innerhalb der festgelegten Abfolge letzten Schließen des Shim-Schalters eines Sekundärstromkreises eine Änderung des elektrischen Stromes im Primärstromkreis durchgeführt, wobei die Höhen der im Primärstromkreis durchzuführenden Änderungen des elektrischen Stromes für die festgelegte Abfolge der Vorgänge so berechnet werden, dass die Summe aller durch die Änderungen des elektrischen Stromes im Primärstromkreis und durch die Schalteröffnungen induzierten Ströme in jedem Sekundärstromkreis einem Sollstrom entspricht, wobei die induktiven Kopplungen zwischen den HTS-Shim-Leiterbahnen untereinander und zwischen der Ladespule und den HTS-Shim-Leiterbahnen berücksichtigt sind. Herkömmlicherweise werden induktiv gekoppelte HTS-Shim-Leiterbahnen gleichzeitig geladen, da bei einem sequentiellen Ladeverfahren das Einfahren eines Stromes in eine der HTS-Shim-Leiterbahnen auch die Ströme in den gekoppelten weiteren HTS-Shim-Leiterbahnen verändern würde. Im Gegensatz dazu werden erfindungsgemäß die HTS-Shim-Leiterbahnen sequentiell geladen (Schalteröffnungen, -schließungen der verschiedenen Sekundärstromkreise und Primärstromanpassungen erfolgen gemäß einer festgelegten Abfolge), wobei während einer Sekundärstromänderung in einer HTS-Shim-Leiterbahn sich der Strom in einer anderen HTS-Shim-Leiterbahn aufgrund der induktiven Kopplung ändern kann. Erfindungsgemäß wird bei der Berechnung der Primärstromanpassungen die induktive Kopplung der HTS-Shim-Leiterbahnen untereinander und die damit verbundenen Stromänderungen in den gekoppelten HTS-Shim-Leiterbahnen berücksichtigt. Insbesondere erlaubt diese Variante das Laden von mehreren Sekundärstromkreisen mittels einer einzigen Ladespule.

Vorzugsweise wird, nachdem der Shim-Schalter eines Sekundärstromkreises innerhalb der Abfolge zum letzten Mal geschlossen wurde, eine Änderung des elektrischen Stromes im Primärstromkreis vorgenommen, bevor der Shim-Schalter eines weiteren Sekundärstromkreises innerhalb der Abfolge zum letzten Mal geschlossen wird. Auf diese Weise wird sichergestellt, dass das für die Berechnung der Höhen der Primärstromanpassungen zu lösende Gleichungssystem eine Lösung besitzt. Vorzugsweise werden innerhalb der Abfolge zuerst die Shim-Schalter derjenigen Sekundärstromkreise zum letzten Mal geschlossen, deren HTS-Shim-Leiterbahnen am wenigsten stark mit anderen HTS-Shim-Leiterbahnen induktiv gekoppelt sind. Hierdurch werden Kopplungseffekte minimiert.

Bei einer speziellen Variante werden die Änderungen des elektrischen Stromes in mehreren Primärstromkreisen mit m>1 verschiedenen Ladespulen, welche induktiv mit den HTS-Shim-Leiterbahnen gekoppelt sind, vorgenommen. So können die Primärstromanpassungen beispielsweise in Ladespulen vorgenommen werden, welche besonders stark mit bestimmten HTS-Shim-Leiterbahnen koppeln.

Eine nicht unter den beanspruchten Schutzumfang fallende Magnetanordnung zur Verwendung in dem zuvor beschriebenen Verfahren kann umfassen: einen Kryostaten mit einer Raumtemperaturbohrung; ein im Kryostaten angeordnetes supraleitendes Magnetspulensystem mit einem Hauptmagneten und mit einer HTS-Shim-Vorrichtung mit mindestens einer HTS-Shim-Leiterbahn zum Einstellen des räumlichen Verlaufs und/oder zur räumlichen Homogenisierung eines vom Magnetspulensystem in einem Arbeitsvolumen erzeugten Magnetfeldes, wobei die HTS-Shim-Leiterbahn als supraleitend kurzschließbare HTS-Spule mit Windungszahl 0 um eine Hauptmagnet-Längsachse ausgebildet ist, wobei die HTS-Shim-Vorrichtung einen Shim-Schalter zur zeitweisen Unterbrechung des supraleitenden Zustandes in einem Abschnitt der HTS-Shim-Leiterbahn umfasst. Die Magnetanordnung umfasst eine Ladevorrichtung mit mindestens einer normalleitenden Ladespule, mindestens einer Energieversorgung und Zuleitungen, welche zusammen einen Primärstromkreis bilden, wobei die Ladespule in der Raumtemperaturbohrung des Kryostaten angeordnet ist oder temporär angeordnet werden kann, wobei die HTS-Shim-Leiterbahn und der Shim-Schalter einen Sekundärstromkreis bilden, wobei die Ladespule und die HTS-Shim-Leiterbahn dazu eingerichtet sind, induktiv miteinander zu koppeln.

Vorzugsweise ist das Stromübersetzungsverhältnis $|M/L_s|$ zwischen der Ladespule und der HTS-Shim-Leiterbahn $\geq 0.01$, insbesondere $\geq 1$, wobei $M$ die Gegeninduktivität zwischen der Ladespule und der HTS-Shim-Leiterbahn und $L_s$ die Eigeninduktivität der HTS-Shim-Leiterbahn bezeichnet. Ein Stromübersetzungsverhältnis in diesen Größenordnungen garantiert, dass die Ladespule nicht mit übermäßig großen elektrischen Strömen betrieben werden muss und eine entsprechend einfache Energieversorgung verwendet werden kann.

Die HTS-Spule der HTS-Shim-Vorrichtung liegt in Form einer geschlossenen HTS-Shim-Leiterbahn vor, deren supraleitender Zustand mittels des supraleitenden Shim-Schalters unterbrochen werden kann. Die HTS-Shim-Leiterbahn umfasst eine HTS-Schicht und bildet eine supraleitend geschlossene Spule mit (in Bezug auf die Hauptmagnet-Längsachse) Windungszahl 0.

Der Kryostat der Magnetanordnung umfasst, sofern er badgekühlt ist, einen Heliumbehälter mit einem Außenmantel und einem Innenrohr, zwischen denen sich flüssiges Helium befindet. Die HTS-Shim-Leiterbahn ist vorzugsweise auf der Innenseite des Heliumbehälter-Innenrohrs des Kryostaten (also radial innerhalb des Heliumbehälters) angeordnet, so dass sich die HTS-Shim-Leiterbahn im Vakuumvolumen befindet und durch den Kontakt mit dem Heliumbehälter gekühlt wird.

Die Ladespule kann als Solenoidspule ausgebildet sein. Vorzugsweise ist die Ladespule aus einem elektrisch gut leitenden Material, insbesondere Kupferdraht, gewickelt.

Aufgrund der Anordnung der Ladespule in der Raumtemperaturbohrung des Kryostaten werden keine Stromzuleitungen von der Energieversorgung im Raumtemperaturbereich in den Kryostaten benötigt. Damit entfällt der damit verbundene Wärmeeintrag in den Kryostaten komplett. Außerdem muss im Kryostaten kein Platz für die Ladespule und die Zuleitungen vorgesehen werden.

Die Ladespule weist eine Ladespulen-Längsachse auf, die vorzugsweise zumindest in der dritten Phase parallel zur Hauptmagnet-Längsachse, insbesondere koaxial zur Hauptmagnet-Längsachse (d.h. Ladespulen-Längsachse = Hauptmagnet-Längsachse) ausgerichtet ist. Diese Ausführungsform ist insbesondere vorteilhaft, da die Kopplung zwischen Ladespule und HTS-Shim-Leiterbahn optimiert werden kann, wenn sie dieselbe Symmetrie, dieselbe Symmetrieachse oder parallele Symmetrieachsen haben. Dies ist der Fall, da die HTS-Shim-Leiterbahn üblicherweise auf einer Zylinderoberfläche mit der Hauptmagnet-Längsachse als Symmetrieachse verläuft. Dank einer stärkeren Kopplung kann die Ladespule dann mit kleineren Strömen betrieben werden.

Um das erfindungsgemässe Verfahren ausführen zu können, muss die HTS-Shim-Vorrichtung mehrere Sekundärstromkreise aufweisen, wobei die HTS-Shim-Leiterbahnen mindestens zweier verschiedener Sekundärstromkreise dazu eingerichtet sein können, mit derselben Ladespule induktiv zu koppeln. Die Ladespule bildet also eine gemeinsame Ladespule für mehrere Sekundärstromkreise. Vorzugsweise sind die HTS-Shim-Leiterbahnen aller Sekundärstromkreise der HTS-Shim-Vorrichtung dazu eingerichtet, mit derselben Ladespule induktiv zu koppeln. Die Verwendung einer einzigen Ladespule zum Laden der gesamten HTS-Shim-Vorrichtung ist insbesondere dann vorteilhaft, wenn der Platz in der Raumtemperaturbohrung begrenzt ist.

Bei einer alternativen Ausgestaltung weist die Ladevorrichtung mehrere Ladespulen auf, wobei die unterschiedlichen Ladespulen dazu eingerichtet sind, mit jeweils unterschiedlichen HTS-Shim-Leiterbahnen der verschiedenen Sekundärstromkreise induktiv zu koppeln. Hierdurch wird ein gleichzeitiges Laden mehrerer Sekundärstromkreise ermöglicht. Die Ladevorrichtung kann einen Magnetfeldsensor aufweisen, welcher radial innerhalb der Ladespule angeordnet ist. Vorzugsweise ist der Magnetfeldsensor zur Messung des Magnetfeldes im Arbeitsvolumen des Magnetspulensystems eingerichtet. Der Magnetfeldsensor kann beispielsweise ein Hall-Sensor oder eine NMR-Probe sein. Damit kann einerseits das Magnetfeld des Magnetspulensystems mit der noch ungeladenen HTS-Shim-Vorrichtung ausgemessen werden, um die nötigen Sollströme der HTS-Shim-Leiterbahnen zu bestimmen. Andererseits kann die Wirkung der HTS-Shim-Vorrichtung auf das Magnetfeld des Magnetspulensystems während und nach dem Ladeverfahren überprüft werden.

In einer weiteren Ausgestaltung umfasst ein Shim-Schalter ein elektrisches Heizelement, in welches durch induktive Kopplung mit einer Primärspule in der Raumtemperaturbohrung des Kryostaten ein Heizstrom induziert werden kann. Diese Ausführungsform hat den Vorteil, dass der Shim-Schalter ohne elektrische Zuleitungen von außen in den Kryostaten und folglich ohne den damit verbundenen Wärmeeintrag in den Kryostaten betrieben werden kann.

Weitere Vorteile der Erfindung ergeben sich aus der Beschreibung und der Zeichnung. Ebenso können die vorstehend genannten und die noch weiter ausgeführten Merkmale erfindungsgemäß jeweils einzeln für sich oder zu mehreren in beliebigen Kombinationen Verwendung finden, sofern die Kombinationen unter den durch die Ansprüche definierten Schutzumfang fallen.

Die gezeigten und beschriebenen Ausführungsformen sind nicht als abschließende Aufzählung zu verstehen, sondern haben vielmehr beispielhaften Charakter für die Schilderung der Erfindung.


Detaillierte Beschreibung der Erfindung und Zeichnung


Fig. 1    zeigt eine Magnetanordnung zur Durchführung des erfindungsgemäßen Verfahrens.

Fig. 2    zeigt eine perspektivische Ansicht einer HTS-Shim-Vorrichtung und einer Ladespule einer Magnetanordnung, bei der die HTS-Shim-Vorrichtung einen einzigen Sekundärstromkreis aufweist und koaxial zur Ladespule angeordnet ist.

Fig. 3    zeigt schematisch die verschiedenen Verfahrensschritte des erfindungsgemäßen Ladeverfahrens ohne Entladen eines Sekundärstromkreises in der ersten Phase.

Fig. 4    zeigt schematisch die verschiedenen Verfahrensschritte des erfindungsgemäßen Ladeverfahrens mit Entladen eines Sekundärstromkreises in der ersten Phase.

Fig. 5    zeigt ein elektrisches Schaltbild einer HTS-Shim-Vorrichtung und einer Ladevorrichtung einer Magnetanordnung zur Durchführung des erfindungsgemäßen Verfahrens gemäß einer Ausführungsform, bei der die HTS-Shim-Vorrichtung mehrere induktiv gekoppelte Sekundärstromkreise aufweist, die mittels einer gemeinsamen Ladespule geladen werden können.

Fig. 6    zeigt ein elektrisches Schaltbild einer HTS-Shim-Vorrichtung und einer Ladevorrichtung einer Magnetanordnung zur Durchführung des erfindungsgemäßen Verfahrens gemäß einer Ausführungsform, bei der die HTS-Shim-Vorrichtung mehrere induktiv gekoppelte Sekundärstromkreise aufweist, die mittels mehrerer Ladespulen geladen werden können.

Fig. 7    zeigt ein Beispiel für die Stromverläufe in der Ladespule (gepunktet) und in zwei HTS-Shim-Leiterbahnen (gestrichelt und gestrichpunktet).


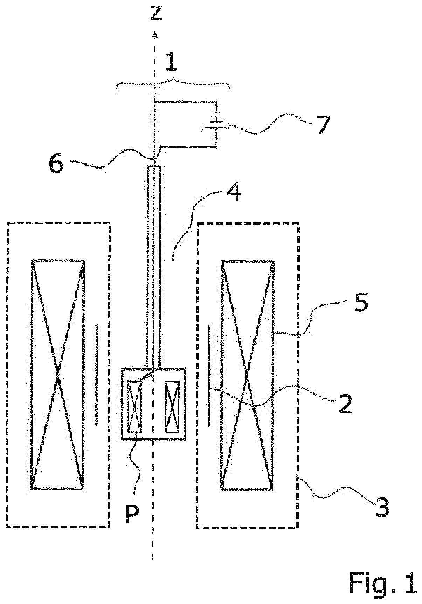

Eine Magnetanordnung zur Durchführung des erfindungsgemäßen Verfahrens ist in **Fig. 1** gezeigt. Sie umfasst einen Kryostaten **3** mit einer Raumtemperaturbohrung **4.** Im Kryostaten 3 befindet sich ein Hauptmagnet **5** zur Erzeugung eines Hauptmagnetfeldes mit einer Hauptmagnet-Längsachse **z** und eine HTS-Shim-Vorrichtung **2** zur Anpassung oder Homogenisierung des Hauptmagnetfeldes. Zum Laden der HTS-Shim-Vorrichtung 2 ist eine Ladevorrichtung **1** vorgesehen, mittels der die HTS-Shim-Vorrichtung 2 induktiv geladen werden kann. Die Ladevorrichtung 1 umfasst eine Ladespule **P,** die über Zuleitungen **6** durch eine Energieversorgung **7** bestromt werden kann. Die Ladespule P ist für den Ladevorgang innerhalb der Raumtemperaturbohrung 4 angeordnet (wie in Fig. 1 gezeigt), so dass die Ladespule P optimal mit der HTS-Shim-Vorrichtung 2 koppeln kann. Der Ladevorgang der HTS-Shim-Vorrichtung 2 erfolgt induktiv.

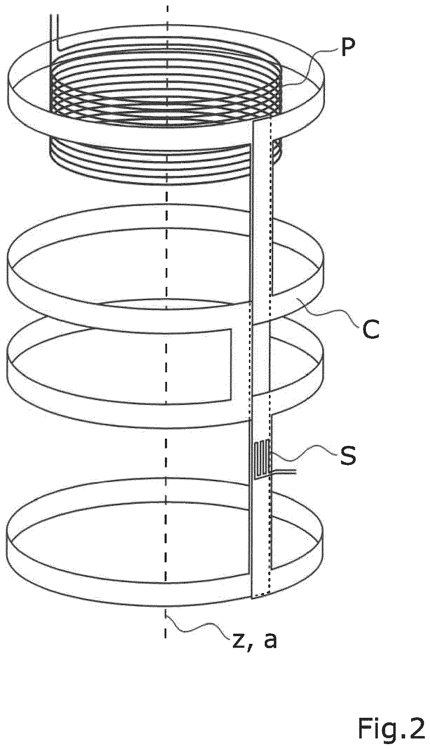

**Fig. 2** zeigt eine bevorzugte relative Anordnung der HTS-Shim-Vorrichtung 2 und der Ladespule P. Der Kryostat 3 ist in Fig. 2 der Übersichtlichkeit halber nicht gezeigt. Aus Fig. 2 erkennt man, dass die HTS-Shim-Vorrichtung 2 als geschlossene HTS-Shim-Leiterbahn **C** ausgeführt ist, die mit einem Shim-Schalter **S** versehen ist, mit dem der supraleitend geschlossene Sekundärstromkreis der HTS-Shim-Leiterbahn C unterbrochen werden kann. Die Ladespule P weist eine Ladespulen-Längsachse **a** auf, die während des Ladevorgangs vorzugsweise mit der Hauptmagnet-Längsachse z übereinstimmt. Nach dem Laden kann die Ladespule P aus der Raumtemperaturbohrung 4 (in Fig. 2 nicht gezeigt) entfernt werden.

Die Ladespule P, die Zuleitungen 6 und die Energieversorgung 7 bilden einen Primärstromkreis und die HTS-Shim-Vorrichtung 2 einen Sekundärstromkreis, wobei der Ladespule P mit der HTS-Shim-Leiterbahn C induktiv koppelt. Die induktive Kopplung zwischen Ladespule P und HTS-Shim-Leiterbahn C ist abhängig von der Position der Ladespule P innerhalb der Raumtemperaturbohrung 4.

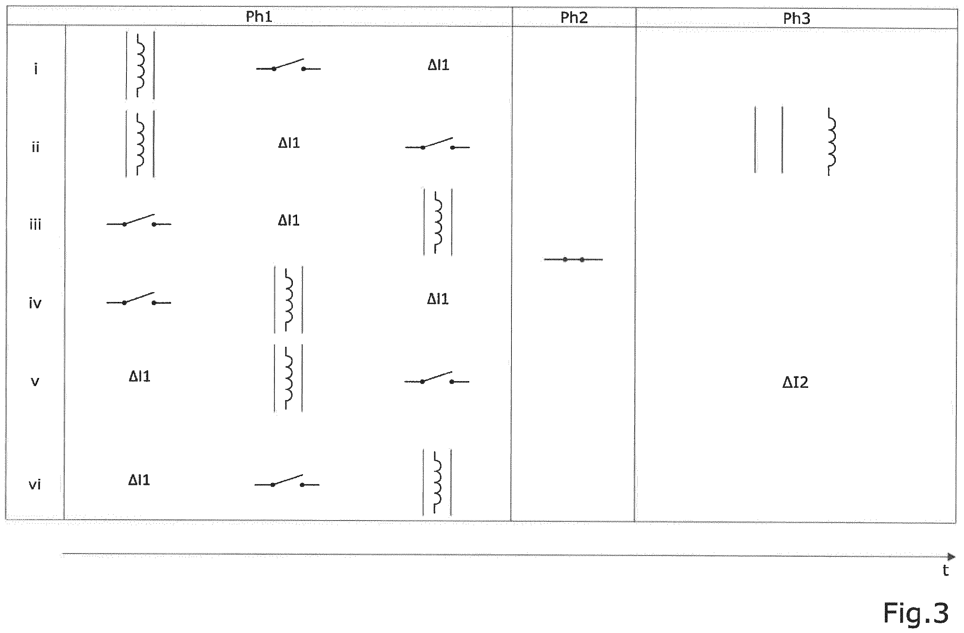

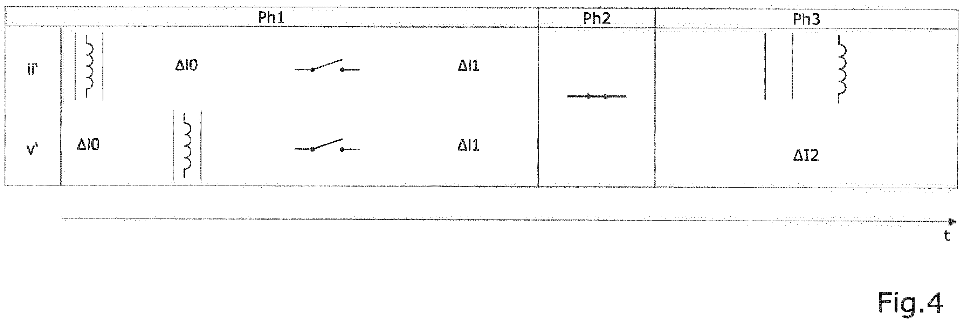

Die HTS-Shim-Vorrichtung 2 der Magnetanordnung wird mittels eines erfindungsgemäßen Ladeverfahrens geladen. Die zeitliche Abfolge der einzelnen Schritte des erfindungsgemäßen Ladeverfahrens ist für eine HTS-Shim-Leiterbahn C in **Fig. 3** (ohne Entladen des Sekundärstromkreises in der ersten Phase **Ph1)** und **Fig. 4** (mit Entladen des Sekundärstromkreises in der ersten Phase Ph1) schematisch dargestellt.

Zunächst werden der Primärstromkreis und der Sekundärstromkreis für das Laden vorbereitet (erste Phase Ph1). Dazu wird die Ladespule P in der Raumtemperaturbohrung 4 der Magnetspulenanordnung platziert (dargestellt durch eine Spule innerhalb eines Rohrlängsschnitts), und mittels der Energieversorgung 7 wird eine erste Primärstromänderung $\Delta I1$ und gegebenenfalls eine Entladestromänderung $\Delta I0$ in der Ladespule P durchgeführt (Bestromen der Ladespule P). Im Sekundärstromkreis wird der Shim-Schalter S geöffnet (dargestellt durch ein Schaltersymbol mit geöffnetem Schalter). Die unterschiedlichen Möglichkeiten, die Schritte der ersten Phase Ph1 durchzuführen, sind in **Fig. 3** gezeigt und mit i - vi bezeichnet.

Durch das Bestromen der zuvor in der Raumtemperaturbohrung 4 platzierten Ladespule P (i, ii, iv) oder durch das Einbringen der bereits mit Strom durchflossenen Ladespule P in die Raumtemperaturbohrung 4 (iii, v, vi) wird am Ort des Sekundärstromkreises eine Änderung des magnetischen Flusses bewirkt. Erfolgt dies in der ersten Phase Ph1 bei geschlossenem Shim-Schalter S im Sekundärstromkreis, kann dies dazu genutzt werden, den Sekundärstromkreis induktiv zu entladen, bevor der Shim-Schalter S geöffnet wird, wie in **Fig. 4** (ii', v') gezeigt. Zur vollständigen Entladung des Sekundärstromkreises wird vor dem Öffnen des Shim-Schalters S eine Entladestromänderung $\Delta I0$ in der Ladespule P durchgeführt, die im Sekundärstromkreis bewirkt, dass sich der Strom im Sekundärstromkreis auf 0 verringert. Die Bestromung der Ladespule P mit der ersten Stromänderung $\Delta I1$ erfolgt dann nach dem Öffnen des Shim-Schalters S.

Ist ein Entladen des Sekundärstromkreises nicht notwendig oder gewünscht, wird der Shim-Schalter S im Sekundärstromkreis vorzugsweise geöffnet, bevor eine Änderung des magnetischen Flusses bewirkt wird. Dazu wird das Einführen der Ladespule P und/oder das Bestromen der Ladespule P nach dem Öffnen des Shim-Schalters S durchgeführt (i, iii, iv, vi).

In einer zweiten Phase **Ph2** wird der Shim-Schalter S geschlossen (dargestellt durch ein Schaltersymbol mit geschlossenem Schalter), so dass der Sekundärstromkreis wieder supraleitend geschlossen ist.

In einer dritten Phase **Ph3** wird durch Ändern der Stromstärke im Primärstromkreis um $\Delta I2$ und/oder durch Entfernen der Ladespule P aus der Raumtemperaturbohrung 4 (dargestellt durch eine Spule außerhalb eines Rohrlängsschnitts) der magnetische Fluss durch die HTS-Shim-Leiterbahn C verändert, so dass im Sekundärstromkreis Strom induziert wird. Die Höhe der Primärstromanpassung $\Delta I2$ in der Ladespule P richtet sich nach dem Strom, der im Sekundärstromkreis nach dem Laden fließen soll und nach der induktiven Kopplung zwischen HTS-Shim-Leiterbahn C und Ladespule P. Vorzugsweise entspricht die erste Stromänderung $\Delta I1$ in der ersten Phase Ph1 der Primärstromanpassung $\Delta I2$ in der dritten Phase Ph3 betragsmäßig, weist aber das umgekehrte Vorzeichen auf.

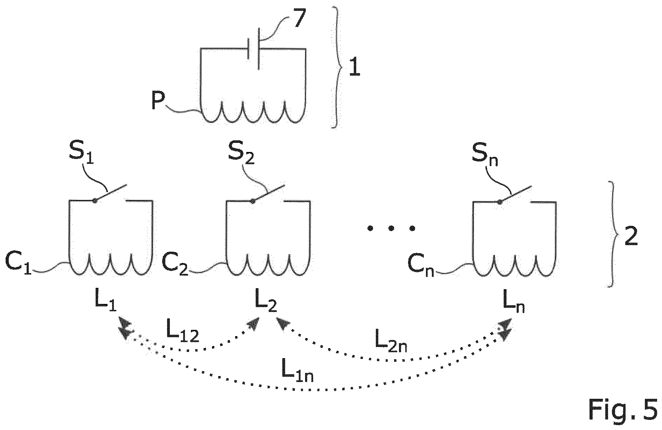

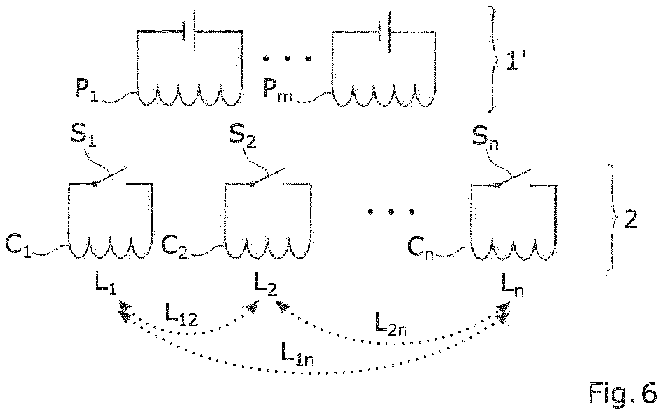

Statt einer einzigen HTS-Shim-Leiterbahn C hat die in dem erfindungsgemässen Verfahren verwendete HTS-Shim-Vorrichtung 2 mehrere (n>1) induktiv gekoppelte HTS-Shim-Leiterbahnen $C_1,...,C_n$, welche je einen Sekundärstromkreis mit je einem Shim-Schalter $S_1,...,S_n$ bilden. Im Ladeverfahren kann eine Ladevorrichtung 1 mit einer einzigen Ladespule P **(Fig. 5)** oder eine Ladevorrichtung **1'** mit mehreren Ladespulen $P_1,...,P_m$ **(Fig. 6)** verwendet werden.

Für jede der HTS-Shim-Leiterbahnen $C_1,...,C_n$ werden die Phasen Ph1, Ph2, Ph3 (erste, zweite und dritte Phase) nacheinander durchlaufen, wobei die erste Phase Ph1 und die dritte Phase Ph3 mehrere Primärstromanpassungen umfassen können. Primärstromanpassungen der dritten Phase Ph3 sind für eine HTS-Leiterbahn $C_1, ..., C_n$ diejenigen Primärstromanpassungen, die nach dem letzten Schließen des Shim-Schalters $S_1, ..., S_n$ des jeweiligen Sekundärstromkreises erfolgen. Je nachdem, in welchen Sekundärstromkreisen der Shim-Schalter $S_1, ..., S_n$ final (also zum letzten Mal innerhalb der Abfolge) geschlossen ist, kann eine bestimmte Primärstromanpassung zur dritten Phase Ph3 des Ladeverfahrens für eine HTS-Shim-Leiterbahn $C_1, ..., C_n$ (bei final geschlossenem Shim-Schalter $S_1, ..., S_n$) und für eine andere HTS-Shim-Leiterbahn $C_1, ..., C_n$ zur ersten Phase Ph1 des Ladeverfahrens (wenn der Shim-Schalter $S_1, ..., S_n$ später noch einmal geöffnet wird) gehören.

Die Berechnung der Primärstromanpassungen für n gekoppelte HTS-Shim-Leiterbahnen $C_1, ..., C_n$ erfolgt wie folgt:

1. Um die Primärströme für eine HTS-Shim-Vorrichtung 2 mit mehreren Sekundärstromkreisen zu berechnen, muss zunächst eine Abfolge (Sequenz) festgelegt werden, während der der Shim-Schalter $S_1, ..., S_n$ jedes Sekundärstromkreises mindestens einmal geöffnet und geschlossen wird. Am Ende der Sequenz sind alle Shim-Schalter $S_1, ..., S_n$ geschlossen. Es werden insgesamt mindestens n Primärstromanpassungen in der/den Ladespule(n) P, $P_1, ..., P_m$ vorgenommen, wobei zwischen zwei Primärstromanpassungen jeweils mindestens ein Shim-Schalter $S_1, ..., S_n$ geöffnet oder geschlossen wird. Zwei zeitlich versetzte Stromänderungen in der Ladespule P, $P_1, ..., P_m$ ohne eine Änderung einer Shim-Schalterstellung wird im Rahmen der vorliegenden Erfindung als eine einzige Primärstromanpassung angesehen.

2. Für jede Änderung einer Shim-Schalterstellung werden die Sekundärstromänderungen in Abhängigkeit von den bis dahin durchgeführten Primärstromanpassungen berechnet.

Bei einer Schalterschließung ändern sich die Ströme in den Sekundärstromkreisen nicht.

Bei einer Schalteröffnung fällt der Strom in der entsprechenden HTS-Shim-Leiterbahn $C_1$, ..., $C_n$ auf 0 A ab, was wiederum Stromänderungen in allen zu diesem Zeitpunkt geschlossenen HTS-Shim-Leiterbahnen $C_1$, ..., $C_n$ induziert. Diese Stromänderungen können als lineare Funktionen der Höhen der bisher vorgenommenen Primärstromanpassungen berechnet werden.

In den HTS-Shim-Leiterbahnen $C_1$, ..., $C_n$ mit geöffneten Shim-Schaltern $S_1$, ..., $S_n$ bleibt der Strom bei 0.

Bei einer Primärstromanpassung werden in allen zu diesem Zeitpunkt geschlossenen HTS-Shim-Leiterbahnen $C_1$, ..., $C_n$ Sekundärstromänderungen induziert. Diese können als lineare Funktionen dieser Primärstromanpassung berechnet werden.

3. Für jede HTS-Shim-Leiterbahn $C_1$, ..., $C_n$ werden die unter Punkt 2 berechneten Sekundärstromänderungen für alle Vorgänge innerhalb der Sequenz addiert und dem Soll- bzw. Endstrom in dieser HTS-Shim-Leiterbahn $C_1$, ..., $C_n$ gleichgesetzt. Dies ergibt n Gleichungen, welche nach den Höhen der mindestens n Primärstromanpassungen aufgelöst werden. Falls die Gleichungen keine Lösung besitzen, war die Sequenz ungünstig gewählt. Wurden mehr als n Primärstromanpassungen vorgenommen, so können die zusätzlichen Primärstromanpassungen dazu verwendet werden, um zusätzliche Bedingungen für die Ströme in den Primär- und Sekundärstromkreisen zu erfüllen.

Im Folgenden wird beispielhaft gezeigt, wie n HTS-Shim-Leiterbahnen $C_1$, ..., $C_n$ der Magnetanordnung induktiv mittels einer Ladevorrichtung 1 mit einer Ladespule P geladen werden können, und die nötigen Primärstromanpassungen berechnet, damit am Ende der Ladesequenz jede HTS-Shim-Leiterbahn $C_j$ ($j = 1, ..., n$) einen vorgegeben elektrischen Sollstrom $I_j$ trägt. Zunächst werden analytische Formeln anhand eines konkreten Ladeverfahrens hergeleitet. Danach wird erläutert, welche Änderungen sich in der Berechnung einer allgemeineren Ladesequenz ergeben.

**Fig. 5** zeigt ein elektrisches Schaltbild von $n \geq 1$ induktiv gekoppelten HTS-Shim-Leiterbahnen $C_1$, ..., $C_n$, welche jeweils eigene supraleitend geschlossene Stromkreise bilden. Die HTS-Shim-Leiterbahnen $C_1$, ..., $C_n$ sind vorzugsweise koaxial zueinander angeordnet (in Fig. 5 nicht gezeigt), wobei die HTS-Shim-Leiterbahnen nicht unbedingt rotationssymmetrisch aufgebaut sind. Jede HTS-Shim-Leiterbahn $C_j$ ist mit einem Shim-Schalter $S_j$ ausgestattet, mit welchem der supraleitende Stromkreis unterbrochen werden kann. Weiter gibt es eine Ladespule P, die von einer Energieversorgung 7 gespeist wird und induktiv mit den HTS-Shim-Leiterbahnen $C_1$, ..., $C_n$, koppelt.

## Ladesequenz

Die Ladesequenz, welche im Folgenden beispielhaft berechnet wird, läuft in n + 1 Schritten (0),..., (n) ab:

(0) Alle Shim-Schalter $S_1$,..., $S_n$ werden geöffnet, sodass die Sekundärstromkreise der HTS-Shim-Leiterbahnen $C_1$,..., $C_n$ keinen Strom tragen. Der Strom in der Ladespule P wird auf einen Wert $\Delta I_0^{(0)}$ gefahren.

(i) Für i = 1,..., n werden nacheinander folgende zwei Vorgänge durchgeführt:

(a) Der Shim-Schalter $S_i$ wird geschlossen (und im weiteren Verfahren nicht mehr geöffnet);

(b) Der Strom in der Ladespule P wird um den Wert $\Delta I_0^{(i)}$ verändert. In Vorgang (b) werden in den supraleitend geschlossenen HTS-Shim-Leiterbahnen $C_1$,..., $C_n$ Sekundärstromänderungen induziert. Zunächst werden diese Sekundärstromänderungen als Funktion der Primärstromanpassungen in der Ladespule P berechnet. Danach werden die Primärstromanpassungen ermittelt, welche in den einzelnen Schritten vorgenommen werden müssen, damit am Ende des Ladeverfahrens jede HTS-Shim-Leiterbahn $C_j$ einen gewünschten Sollstrom $I_j$ trägt.

## Induzierte Stromänderungen

In diesem Abschnitt wird ein einzelner Schritt (i) betrachtet:

Durch die Primärstromanpassung $\Delta I_0^{(i)}$ in der Ladespule P ändern sich in Vorgang (b) die 'externen' magnetischen Flüsse durch die HTS-Shim-Leiterbahnen $C_1$,..., $C_i$ mit geschlossenen Shim-Schaltern $S_1$,..., $S_i$, beschrieben durch den Flussänderungsvektor

$$\Delta\phi^{(i)} = (\Delta\phi_1^{(i)},\ldots,\Delta\phi_i^{(i)})^T = \mathbf{L}_0^{(i)}\Delta I_0^{(i)} \quad \text{mit } \mathbf{L}_0^{(i)} = (L_{01},\ldots,L_{0i})^T. \tag{1}$$

Die Vektorkomponenten $L_{01},..., L_{0i}$ beschreiben die induktiven Kopplungen bzw. Gegeninduktivitäten zwischen der Ladespule P und den HTS-Shim-Leiterbahnen $C_1,..., C_i$. Aufgrund der Flusserhaltung werden diese externen Flussänderungen durch induzierte Ströme in den supraleitend geschlossenen Sekundärstromkreisen kompensiert. Der Zusammenhang zwischen Flussänderungen und induzierten Sekundärstromänderungen wird durch die (i x i)-Induktivi-tätsmatrix $\hat{L}^{(i)}$ beschrieben, wobei die Matrixelemente $L_{jk} = L_{kj}$ (j,k = 1,..., i) für die Eigeninduktivitäten (j = k) und die Gegeninduktivitäten (j ≠ k) der HTS-Shim-Leiterbahnen $C_1,..., C_i$ stehen:

$$\hat{L}^{(i)} \Delta \mathbf{I}^{(i)} = -\Delta \phi^{(i)} . \qquad (2)$$

Hier ist $\Delta I^{(i)} = (\Delta I_1,...,\Delta I_i)^T$ der Stromänderungsvektor. Durch Invertieren der Gleichung (2) können die induzierten Stromänderungen in den supraleitend geschlossenen Sekundärstromkreisen als Funktion der Primärstromanpassung in der Ladespule P ausgedrückt werden,

$$\Delta \mathbf{I}^{(i)} = -\hat{L}^{(i)-1} \mathbf{L}_0^{(i)} \cdot \Delta I_0^{(i)} . \qquad (3)$$

Man beachte, dass die Sekundärstromkreise der HTS-Shim-Leiterbahnen $C_{i+1},..., C_n$ mit geöffneten Shim-Schaltern $S_{i+1},..., S_n$ bis am Ende des Schrittes (i) keinen Strom tragen, d.h. $\Delta I_{j>i}^{(i)} = 0$ .

Berechnung der Primärstromanpassungen

Die Ströme in den HTS-Shim-Leiterbahnen $C_1,..., C_n$ am Ende des Verfahrens ergeben sich allgemein aus den Summen der induktiven Sekundärstromänderungen aller Schritte,

$$\sum_{i=1}^{n} \Delta I_j^{(i)} = I_j \quad \text{für } (j = 1,...,n) \quad \text{oder in Vektor-Form} \quad \sum_{i=1}^{n} \Delta \mathbf{I}^{(i)} = \mathbf{I}, \qquad (4)$$

und werden den Sollströmen $I_1,..., I_n$ der HTS-Shim-Leiterbahnen $C_1,..., C_n$ gleichgesetzt werden. Die n linearen Skalargleichungen lassen sich dann unter Verwendung von Gleichung (3) nach den n Primärstromanpassungen $\Delta I_0^{(i)}$ auflösen. Die allererste Primärstromanpassung um $\Delta I_0^{(0)}$ in der Ladespule P beeinflusst die Ströme in den Sekundärstromkreisen nicht, und kann so gewählt werden, dass der Strom $I_0$ in der Ladespule P am Ende des Verfahrens gleich 0 ist:

$$I_0 = \sum_{i=0}^{n} \Delta I_0^{(i)} = 0 \quad \text{bzw. } \Delta I_0^{(0)} = - \sum_{i=1}^{n} \Delta I_0^{(i)} . \qquad (5)$$

Für das hier beschriebene konkrete Beispiel, in dem der Shim-Schalter $S_j$ jeweils bis zum Schritt (j - 1) geöffnet ist und die HTS-Shim-Leiterbahn $C_j$ bis zu diesem Zeitpunkt keinen Strom trägt, lässt sich Gleichung (4) als

$$I_j = \sum_{i=j}^{n} \Delta I_j^{(i)} \quad \text{oder} \quad \Delta I_j^{(j)} = I_j - \sum_{k=j+1}^{n} \Delta I_j^{(k)} \quad (\text{für } j = 1,...,n) \qquad (6)$$

schreiben. Die letzte induktive Sekundärstromänderung in der HTS-Shim-Leiterbahn $C_n$ muss also gerade ihrem Soll-strom

$$\Delta I_n^{(n)} \equiv I_n \qquad (7)$$

entsprechen. Gleichung (3) ergibt dann die Höhe der entsprechend notwendigen Primärstromanpassung in der La-despule P,

$$\Delta I_0^{(n)} = - \frac{I_n}{\sum_{j=1}^{n} \left( L^{(n)-1} \right)_{nj} L_{0j}^{(n)}} . \qquad (8)$$

Die weiteren Sekundärstromänderungen und die dafür notwendigen Primärstromanpassungen können gemäss der Formel (6) auf diese Weise nacheinander für jede HTS-Shim-Leiterbahn $C_{n-1}, C_{n-2}, ..., C_1$ rückwärts berechnet werden.

### Mehrere Ladespulen $P_1, ..., P_m$

Anstelle einer einzigen Ladespule P können in den Ladeschritten auch m verschiedene Ladespulen $P_1, ..., P_m$ verwendet werden, wie in Fig. 6 gezeigt. In Gleichung (3) muss dann entsprechend mit den Kopplungen $L_0^{(i)}$ zwischen der verwendeten Ladespule $P_1, ..., P_m$ und den HTS-Shim-Leiterbahnen $C_1, ..., C_n$ gerechnet werden. In Schritt (0) der Ladesequenz kann bei geöffneten Shim-Schaltern $S_1, ..., S_n$ der Primärstrom in jeder Ladespule $P_1, ..., P_m$ so angepasst werden, dass die Primärströme am Ende der Sequenz einen bestimmten Wert, z. B. 0 A, erreichen, siehe Gleichung (5).

### Zusätzliche Schalteröffnungen und -schließungen

Der Shim-Schalter $S_j$ zu einer HTS-Shim-Leiterbahn $C_j$ kann von Anfang geschlossen sein oder auch in einem Schritt (i < j) geschlossen werden. In der Berechnung der Primärstromanpassungen müssen in Gleichung (3) jeweils alle HTS-Shim-Leiterbahnen mit geschlossenen Shim-Schaltern berücksichtigt werden. Wird der Shim-Schalter $S_j$ in einem Schritt (i ≤ j) wieder geöffnet, dann fällt der Strom im Sekundärstromkreis der HTS-Shim-Leiterbahn $C_j$ auf 0 ab, wodurch sich die Ströme in den anderen geschlossenen Sekundärstromkreisen induktiv verändern. Diese Sekundärstromänderungen können analog zum im oben beschriebenen Fall einer Primärstromanpassung in der Ladespule P, $P_1, ..., P_m$ berechnet werden, und müssen in den Gleichungen (4) als zusätzliche Summanden berücksichtigt werden.

Die Anzahl der Gleichungen sowie der Unbekannten $\Delta I_0^{(i)}$ bleibt n, so dass eine eindeutige mathematische Lösung auch in diesem Fall gefunden werden kann.

### Zusätzliche Stromrampen

Vor oder nach jeder zusätzlichen Änderung eines Schalterzustandes (wie zuvor beschrieben) kann im Prinzip eine zusätzliche Primärstromanpassung vorgenommen werden, welche die Ströme in den supraleitend geschlossenen Sekundärstromkreisen beeinflusst. Dies ergibt zusätzliche Freiheitsgrade im Problem, so dass es i. A. nicht nur eine Lösung für die Primärstromanpassungen gibt, um die vorgegebenen Sollströme für die HTS-Shim-Leiterbahnen $C_1, ..., C_n$ zu erreichen. Diese Tatsache kann ausgenutzt werden, um zusätzliche Bedingungen zu erfüllen. Beispielsweise kann eine zusätzliche Primärstromanpassung so gewählt werden, dass der induzierte Strom in einem Sekundärstromkreis auf 0 geht, bevor sein Shim-Schalter geöffnet wird. Solche zusätzlichen Primärstromanpassungen können analog zu den oben beschriebenen Berechnungen behandelt werden.

### Beispiel: HTS-Shim-Vorrichtung 2 mit zwei HTS-Shim-Leiterbahnen $C_1$ und $C_2$ und anfänglich geschlossenen Shim-Schaltern $S_1$ und $S_2$

Als Beispiel für eine allgemeinere Ladesequenz mit zusätzlichen Schaltvorgängen und Stromrampen werden zwei gekoppelte HTS-Shim-Leiterbahnen $C_1$ und $C_2$ mit anfänglich geschlossenen Shim-Schaltern $S_1$, $S_2$ und eine Ladespule P betrachtet. Die elektrischen Ströme in den beiden HTS-Shim-Leiterbahnen $C_1$ und $C_2$ sowie in der Ladespule P seien am Anfang 0. Das Laden laufe folgendermaßen ab:

1. Der Shim-Schalter $S_1$ des Sekundärstromkreises mit der HTS-Shim-Leiterbahn $C_1$ wird geöffnet, der Primärstrom in der Ladespule P wird um $\Delta I_0^{(1)}$ angepasst;

2. Der Shim-Schalter $S_1$ wird geschlossen, der Primärstrom in der Ladespule P wird um $\Delta I_0^{(2)}$ angepasst;

3. Der Shim-Schalter $S_2$ des Sekundärstromkreises mit der HTS-Shim-Leiterbahn $C_2$ wird geöffnet, der Primärstrom in der Ladespule P wird um $\Delta I_0^{(3)}$ angepasst;

4. Der Shim-Schalter $S_2$ wird geschlossen, der Primärstrom in der Ladespule P wird um $\Delta I_0^{(4)}$ angepasst.

Die Sequenz umfasst insgesamt vier Primärstromanpassungen in der Ladespule P. Entsprechend diesen vier Freiheitsgraden können vier Bedingungen definiert werden:

B1: Der Endstrom in der HTS-Shim-Leiterbahn $C_1$ soll $I_1$ betragen.
B2: Der Endstrom in der HTS-Shim-Leiterbahn $C_2$ soll $I_2$ betragen.
B3: Die HTS-Shim-Leiterbahn $C_2$ soll vor der Schalteröffnung in Schritt (3) keinen Strom tragen.
B4: Die Ladespule P soll am Ende der Sequenz keinen Strom tragen.

Man beachte, dass ohne B3 die HTS-Shim-Leiterbahn $C_2$ bei der Schalteröffnung eine Sekundärstromänderung auf 0 erfahren würde, welche wiederum eine Sekundärstromänderung in der supraleitend geschlossenen HTS-Shim-Leiterbahn $C_1$ induzieren würde. B1 - B4 ergeben folgende Gleichungen, wobei sich die Indizes auf die in diesem Abschnitt beschriebene Ladesequenz beziehen:

$$\Delta I_1^{(1)} + \Delta I_1^{(2)} + \Delta I_1^{(3)} + \Delta I_1^{(4)} = I_1 \tag{9}$$

$$\Delta I_2^{(1)} + \Delta I_2^{(2)} + \Delta I_2^{(3)} + \Delta I_2^{(4)} = I_2 \tag{10}$$

$$\Delta I_2^{(1)} + \Delta I_2^{(2)} = 0 \tag{11}$$

$$\Delta I_0^{(1)} + \Delta I_0^{(2)} + \Delta I_0^{(3)} + \Delta I_0^{(4)} = 0 \tag{12}$$

Aus der Ladesequenz folgt sofort $\Delta I_1^{(1)} = 0$ und $\Delta I_2^{(3)} = 0$, da der Shim-Schalter $S_1$ im 1. Schritt und der Shim-Schalter $S_2$ im 3. Schritt während der jeweiligen Primärstromanpassung geöffnet sind. Die weiteren induzierten Sekundärstromänderungen $\Delta I_{1,2}^{(j)}$ (j = 1,...,4) können mittels Gleichung (3) durch die Primärstromanpassung $\Delta I_0^{(1,...,4)}$ ausgedrückt werden. Die Gleichungen (9-12) können somit aufgelöst werden:

$$\Delta I_0^{(1)} = \frac{L_1 L_2}{L_{01} L_2 - L_{02} L_{12}} \cdot I_1 + \frac{L_2 L_{12}}{L_{01} L_2 - L_{02} L_{12}} \cdot I_2 \tag{13}$$

$$\Delta I_0^{(2)} = \frac{L_{02} L_1 (L_1 L_2 - L_{12}^2)}{(L_{01} L_{12} - L_{02} L_1)(L_{01} L_2 - L_{02} L_{12})} \cdot I_1 + \frac{L_{02} L_{12} (L_1 L_2 - L_{12}^2)}{(L_{01} L_{12} - L_{02} L_1)(L_{01} L_2 - L_{02} L_{12})} \cdot I_2 \tag{14}$$

$$\Delta I_0^{(3)} = -\frac{L_1 L_{12}}{L_{01} L_{12} - L_{02} L_1} \cdot I_1 - \frac{L_1 L_2}{L_{01} L_{12} - L_{02} L_1} \cdot I_2 \tag{15}$$

$$\Delta I_0^{(4)} = \frac{L_1 L_2 - L_{12}^2}{L_{01} L_{12} - L_{02} L_1} \cdot I_2 \, . \tag{16}$$

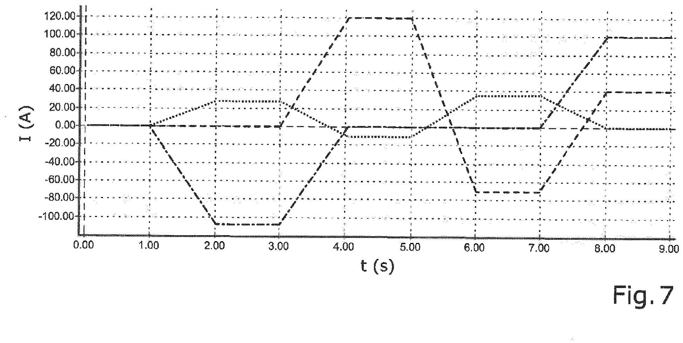

Ein Beispiel der zeitlichen Stromverläufe für diese Ladesequenz ist für die Sollströme $I_1$ = 40 A und $I_2$ = 100 A in **Fig. 7** dargestellt. Bei dem gezeigten Beispiel wird der Shim-Schalter $S_1$ bei t = 0 s geöffnet und bei 2.5 s geschlossen. Der Shim-Schalter $S_2$ wird bei 4.5 s geöffnet und bei 6.5 s geschlossen. Man kann leicht erkennen, dass alle vier gestellten Bedingungen B1 - B4 erfüllt sind.

**Bezuaszeichenliste**

1, 1'        Ladevorrichtung

| 2 | HTS-Shim-Vorrichtung |
|---|---|
| 3 | Kryostat |
| 4 | Raumtemperaturbohrung |
| 5 | Hauptmagnet |
| 6 | Zuleitungen |
| 7 | Energieversorgung |
| a | Ladespulen-Längsachse |
| $C, C_1, ..., C_n$ | HTS-Shim-Leiterbahnen |
| $P, P_1, ..., P_m$ | Ladespulen |
| Ph1 | Erste Phase |
| Ph2 | Zweite Phase |
| Ph3 | Dritte Phase |
| $S, S_1, ..., S_n$ | Shim-Schalter |
| z | Hauptmagnet-Längsachse |

**Literaturliste**

[01] US 8,965,468 B2

[02] Y. Iwasa et al. "Persistent-mode high-temperature superconductor shim coils: A design concept and experimental results of a prototype Z1 high-temperature superconductor shim" Appl. Phys. Lett. 103, 052607 (2013)

[03] DE 10 2016 225 017 A1

[04] US 9,671,479 B2

[05] T.A. Coombs et al. "Flux pumps for HTS coils" MAGNETICS TECHNOLOGY INTERNATIONAL 2017, S. 44-49

[06] J. Geng et al. "Mechanism of a high-Tc superconducting flux pump: Using alternating magnetic field to trigger flux flow", S. 1-4 APPLIED PHYSICS LETTERS 107, 142601 (2015)

[07] S. Lee et al. "Persistent Current Mode Operation of A 2G HTS Coil With A Flux Pump" IEEE TRANSACTIONS ON APPLIED SUPERCONDUCTIVITY, VOL. 26, NO. 4, June 2016

[08] C. W. Bumby et al. "Through-Wall Excitation of a Magnet Coil by an External-Rotor HTS Flux Pump" IEEE TRANSACTIONS ON APPLIED SUPERCONDUCTIVITY, VOL. 26, NO. 4, June 2016

[09] WO 2007/004787 A2

[10] D. Park et al. "HTS Shim Coils Energized by a Flux Pump for the MIT 1.3-GHz LTS/HTS NMR Magnet: Design, Construction, and Results of a Proof-of-Concept Prototype" IEEE TRANSACTIONS ON APPLIED SUPERCONDUCTIVITY, VOL. 28, NO. 3, April 2018

[11] GB 2 424 284 A

[12] US 9,810,755 B2

[13] DE 10 2015 218 019 A1

[14] US 6,014,069 A

**Patentansprüche**

1. Verfahren zum Laden einer HTS-Shim-Vorrichtung (2) eines in einem Kryostaten (3) mit einer Raumtemperaturbohrung (4) angeordneten supraleitenden Magnetspulensystems mittels einer Ladevorrichtung (1, 1'), wobei die HTS-Shim-Vorrichtung (2) n>1 supraleitend geschlossene HTS-Shim-Leiterbahnen ($C_1, ..., C_n$) mit je einem Shim-Schalter ($S_1, ..., S_n$) zur zeitweisen Unterbrechung des supraleitenden Zustandes in einem Abschnitt der entsprechenden HTS-Shim-Leiterbahn ($C_1, ..., C_n$) umfasst, wobei die HTS-Shim-Leiterbahnen ($C_1, ..., C_n$) mit den Shim-Schaltern ($S_1, ..., S_n$) je einen Sekundärstromkreis bilden, wobei die HTS-Shim-Leiterbahnen ($C_1, ..., C_n$) der Sekundärstromkreise induktiv miteinander gekoppelt sind,

wobei die Ladevorrichtung (1, 1') mindestens eine normalleitende Ladespule ($P_1, ..., P_m$), mindestens eine Energieversorgung (7) und Zuleitungen (6) umfasst und mindestens einen Primärstromkreis bildet, und eine Änderung des elektrischen Stroms im Sekundärstromkreis induktiv mittels einer Änderung des von der Ladespule ($P_1, ..., P_m$) erzeugten magnetischen Flusses durch die von der jeweiligen HTS-Shim-Leiterbahn ($C_1, ..., C_n$) eingeschlossene Fläche erfolgt, wobei

in einer ersten Phase (Ph1) in beliebiger Reihenfolge

- der Shim-Schalter ($S_1$, ..., $S_n$) zur Unterbrechung des supraleitenden Zustandes in einem Abschnitt der HTS-Shim-Leiterbahn ($C_1$, ..., $C_n$) mindestens zeitweise geöffnet wird,
- die Ladespule ($P_1$, ..., $P_m$) in die Raumtemperaturbohrung (4) des Kryostaten (3) positioniert wird, und
- zumindest eine Änderung des elektrischen Stroms im Primärstromkreis vorgenommen wird;

in einer zweiten Phase (Ph2) die HTS-Shim-Leiterbahn ($C_1$, ..., $C_n$) durch Schließen des Shim-Schalters ($S_1$, ..., $S_n$) supraleitend geschlossen wird; und

in einer dritten Phase (Ph3) bei geschlossenem Shim-Schalter ($S_1$, ..., $S_n$) der elektrische Strom im Primärstromkreis verändert und/oder die Ladespule ($P_1$, ..., $P_m$) aus der Raumtemperaturbohrung (4) entfernt wird,

wobei eine Abfolge von Schalteröffnungen und Schalterschließungen der Shim-Schalter ($S_1$, ..., $S_n$) der Sekundärstromkreise und eine Abfolge von Änderungen des elektrischen Stroms im Primärstromkreis festgelegt wird,

wobei nach jedem innerhalb der festgelegten Abfolge letzten Schließen des Shim-Schalters ($S_1$, ..., $S_n$) eines Sekundärstromkreises eine Änderung des elektrischen Stromes im Primärstromkreis durchgeführt wird, wobei die Höhen der im Primärstromkreis durchzuführenden Änderungen des elektrischen Stromes für die festgelegte Abfolge der Vorgänge so berechnet werden, dass die Summe aller durch die Änderungen des elektrischen Stromes im Primärstromkreis und durch die Schalteröffnungen induzierten Ströme in jedem Sekundärstromkreis einem Sollstrom entspricht, wobei die induktiven Kopplungen zwischen den HTS-Shim-Leiterbahnen ($C_1$, ..., $C_n$) untereinander und zwischen der Ladespule ($P_1$, ..., $P_m$) und den HTS-Shim-Leiterbahnen ($C_1$, ..., $C_n$) berücksichtigt sind.

2. Verfahren nach Anspruch 1, **dadurch gekennzeichnet,**

**dass** in der ersten Phase (Ph1) zum Einstellen des elektrischen Stroms im Primärstromkreis der elektrische Strom im Primärstromkreis hochgefahren wird, und

**dass** zum Anpassen des elektrischen Stroms im Primärstromkreis in der dritten Phase (Ph3) der elektrische Strom im Primärstromkreis heruntergefahren wird.

3. Verfahren nach Anspruch 2, **dadurch gekennzeichnet,**
**dass** zum Entladen des Sekundärstromkreises in der ersten Phase (Ph1) bei supraleitend kurzgeschlossenem Sekundärstromkreis der elektrische Strom in der Ladespule ($P_1$, ..., $P_m$) so eingestellt wird, dass der elektrische Strom im Sekundärstromkreis auf 0 abfällt.

4. Verfahren nach einem der vorhergehenden Ansprüche, **dadurch gekennzeichnet, dass** in der ersten Phase (Ph1) zumindest eine der Änderungen des elektrischen Stromes im Primärstromkreis nach Öffnen des Shim-Schalters ($S_1$, ..., $S_n$) erfolgt.

5. Verfahren nach einem der vorhergehenden Ansprüche, **dadurch gekennzeichnet, dass**, nachdem der Shim-Schalter ($S_1$, ..., $S_n$) eines Sekundärstromkreises innerhalb der Abfolge zum letzten Mal geschlossen wurde, eine Änderung des elektrischen Stromes im Primärstromkreis vorgenommen wird, bevor der Shim-Schalter ($S_1$, ..., $S_n$) eines weiteren Sekundärstromkreises innerhalb der Abfolge zum letzten Mal geschlossen wird.

6. Verfahren nach einem der vorhergehenden Ansprüche, **dadurch gekennzeichnet, dass** innerhalb der Abfolge zuerst die Shim-Schalter ($S_1$, ..., $S_n$) derjenigen Sekundärstromkreise zum letzten Mal geschlossen werden, deren HTS-Shim-Leiterbahnen ($C_1$, ..., $C_n$) am wenigsten stark mit anderen HTS-Shim-Leiterbahnen ($C_1$, ..., $C_n$) induktiv gekoppelt sind.

7. Verfahren nach einem der vorhergehenden Ansprüche, **dadurch gekennzeichnet, dass** die Änderungen des elektrischen Stromes in mehreren Primärstromkreisen mit m>1 verschiedenen Ladespulen ($P_1$, ..., $P_m$), welche induktiv mit den HTS-Shim-Leiterbahnen ($C_1$, ..., $C_n$) gekoppelt sind, vorgenommen werden.

**Claims**

1. A method for charging an HTS shim device (2) of a superconducting magnet coil system arranged in a cryostat (3) having a room temperature bore (4) by means of a charging device (1, 1'), the HTS shim device (2) comprising n>1 superconductingly closed HTS shim conductor paths ($C_1$, ..., $C_n$) with one shim switch ($S_1$, ..., $S_n$) each for temporarily interrupting the superconducting state in a section of the corresponding HTS shim conductor path ($C_1$, ..., $C_n$), wherein the HTS shim conductor paths ($C_1$, ..., $C_n$) each form a secondary circuit with the shim switches ($S_1$, ..., $S_n$), wherein the HTS shim conductor paths ($C_1$, ..., $C_n$) of the secondary circuits are inductively coupled,

wherein the charging device (1, 1') comprises at least one normal-conducting charging coil ($P_1$, ..., $P_m$), at least one power supply (7) and supply lines (6) and forms at least one primary circuit, and a change in the electric current in the secondary circuit inductively occurs by means of a change of the magnetic flux generated by the charging coil ($P_1$, ..., $P_m$) through the surface enclosed by the respective HTS shim conductor path ($C_1$, ..., $C_n$), wherein
in a first phase (Ph1) in any order

- the shim switch ($S_1$, ..., $S_n$) for interrupting the superconducting state in a section of the HTS shim conductor path ($C_1$, ..., $C_n$) is at least temporarily opened,
- the charging coil ($P_1$, ..., $P_m$) is positioned in the room temperature bore (4) of the cryostat (3), and
- at least a change of the electric current in the primary circuit is carried out;

in a second phase (Ph2) the HTS shim conductor path ($C_1$, ..., $C_n$) is superconductingly closed by closing the shim switch ($S_1$, ..., $S_n$); and
in a third phase (Ph3) with the shim switch ($S_1$, ..., $S_n$) closed the electric current in the primary circuit is changed and/or the charging coil ($P_1$, ..., $P_m$) is removed from the room temperature bore (4), wherein a sequence of switch openings and switch closures of the shim switches ($S_1$, ..., $S_n$) of the secondary circuits and a sequence of changes in the electric current in the primary circuit are determined, wherein after each last closure of the shim switch ($S_1$, ..., $S_n$) of a secondary circuit within the predetermined sequence a change in the electric current in the primary circuit is performed, wherein the values of the changes in the electric current to be performed in the primary circuit are calculated for the predetermined sequence of the actions such that the sum of all the currents induced by the changes in the electric current in the primary circuit and by the switch openings corresponds to a target current in each secondary circuit, the inductive couplings between the HTS shim conductor paths ($C_1$, ..., $C_n$) with each other and between the charging coil ($P_1$, ..., $P_m$) and the HTS shim conductor paths ($C_1$, ..., $C_n$) are considered.

2. A method according to claim 1, **characterized in that**

in the first phase (Ph1) for adjusting the electric current in the primary circuit, the electric current in the primary circuit is increased, and
for adjusting the electric current in the primary circuit in the third phase (Ph3), the electric current in the primary circuit is reduced.

3. A method according to claim 2, **characterized in that**
in order to discharge the secondary circuit in the first phase (Ph1) in the case of a superconductingly short-circuited secondary circuit, the electric current in the charging coil ($P_1$, ..., $P_m$) is set so that the electric current in the secondary circuit drops to 0.

4. Method according to one of the preceding claims, **characterized in that** in the first phase (Ph1) at least one of the changes of the electric current in the primary circuit takes place after opening the shim switch ($S_1$, ..., $S_n$).

5. A method according to one of the preceding claims, **characterized in that**, after the shim switch ($S_1$, ..., $S_n$) of a secondary circuit has been closed for the last time within the sequence, a change in the electric current in the primary circuit is performed before the shim switch ($S_1$, ..., $S_n$) of another secondary circuit within the sequence is closed for the last time.

6. A method according to one of the preceding claims, **characterized in that**, within the sequence, the shim switches ($S_1$, ..., $S_n$) of those secondary circuits are first closed for the last time, whose HTS shim conductor paths ($C_1$, ..., $C_n$) are inductively coupled with other HTS shim conductor paths ($C_1$, ..., $C_n$) to the least strong degree.

7. A method according to one of the preceding claims, **characterized in that** the changes in the electric current are performed in a plurality of primary circuits with m > 1 different charging coils ($P_1$, ..., $P_m$), which are inductively coupled with the HTS shim conductor paths ($C_1$, ..., $C_n$).

**Revendications**

1. Procédé de charge d'un dispositif de calage HTS (2) d'un système de bobines magnétiques supraconductrices disposé dans un cryostat (3), pourvu d'un alésage à température ambiante (4), au moyen d'un dispositif de charge (1, 1'), le dispositif de calage HTS (2) comprenant $n > 1$ bandes conductrices de calage HTS ($C_1$, ..., $C_n$) fermées de manière supraconductrice et comportant chacune un commutateur de calage ($S_1$,..., $S_n$) destiné à interrompre temporairement l'état supraconducteur dans une portion de la bande conductrice de calage HTS ($C_1$,..., $C_n$) correspondante, les bandes conductrices de calage HTS ($C_1$,... ; $C_n$) munies des commutateurs de calage ($S_1$,..., $S_n$) formant chacune un circuit secondaire, les bandes conductrices de calage HTS ($C_1$,..., $C_n$) des circuits secondaires étant couplées entre elles par induction, le dispositif de charge (1, 1') comprenant au moins une bobine de charge normalement conductrice ($P_1$,..., $P_m$), au moins une alimentation en énergie (7) et des conducteurs (6) et formant au moins un circuit primaire, et une variation du courant électrique dans le circuit secondaire étant effectuée par induction au moyen d'une variation du flux magnétique, généré par la bobine de charge ($P_1$,..., $P_m$), à travers la surface délimitée par la bande conductrice de calage HTS respective ($C_1$,..., $C_n$),

   dans une première phase (Ph1) dans un ordre quelconque

   • le commutateur de calage ($S_1$,..., $S_n$) étant ouvert au moins temporairement pour interrompre l'état supraconducteur dans une portion de la bande conductrice de calage HTS ($C_1$,..., $C_n$),
   • la bobine de charge ($P_1$,..., $P_m$) étant positionnée dans l'alésage à température ambiante (4) du cryostat (3), et
   • au moins une variation du courant électrique étant effectuée dans le circuit primaire ;

   dans une deuxième phase (Ph2) la bande conductrice de calage HTS ($C_1$,..., $C_n$) étant fermée de manière supraconductrice par fermeture du commutateur de calage ($S_1$,..., $S_n$) ; et
   dans une troisième phase (Ph3), lorsque le commutateur de calage ($S_1$,..., $S_n$) est fermé, le courant électrique dans le circuit primaire étant modifié et/ou la bobine de charge ($P_1$,..., $P_m$) étant retirée de l'alésage à température ambiante (4),

   une séquence d'ouvertures et de fermetures des commutateurs de calage ($S_1$,..., $S_n$) des circuits secondaires et une séquence de variations du courant électrique dans le circuit primaire étant définies,
   après chaque dernière fermeture du commutateur de calage ($S_1$,..., $S_n$) d'un circuit secondaire dans la séquence définie, une variation du courant électrique étant effectuée dans le circuit primaire, les amplitudes des variations du courant électrique à effectuer dans le circuit primaire pour la séquence définie de processus étant calculées de telle sorte que la somme de tous les courants induits par les variations du courant électrique dans le circuit primaire et par les ouvertures des commutateurs corresponde dans chaque circuit secondaire à un courant cible, les couplages inductifs entre les bandes conductrices de calage HTS ($C_1$,..., $C_n$) entre elles et entre la bobine de charge ($P_1$,..., $P_m$) et les bandes conductrices de calage HTS ($C_1$,..., $C_n$) étant pris en compte.

2. Procédé selon la revendication 1, **caractérisé en ce que**

   dans la première phase (Ph1) le courant électrique dans le circuit primaire est augmenté afin de régler le courant électrique dans le circuit primaire, et
   dans la troisième phase (Ph3), le courant électrique dans le circuit primaire est abaissé afin d'adapter le courant électrique dans le circuit primaire.

3. Procédé selon la revendication 2, **caractérisé en ce que**
   pour décharger le circuit secondaire dans la première phase (Ph1) lorsque le circuit secondaire est court-circuité par supraconduction, le courant électrique dans la bobine de charge ($P_1$,..., $P_m$) est réglé de telle sorte que le courant électrique dans le circuit secondaire tombe à 0.

4. Procédé selon l'une des revendications précédentes, **caractérisé en ce que** dans la première phase (Ph1) au moins une des variations du courant électrique dans le circuit primaire est effectuée après ouverture du commutateur de calage ($S_1$,..., $S_n$).

5. Procédé selon l'une des revendications précédentes, **caractérisé en ce que**, après que le commutateur de calage ($S_1$,... $S_n$) d'un circuit secondaire a été fermé pour la dernière fois dans la séquence, une variation du courant électrique dans le circuit primaire est effectuée avant que le commutateur de calage ($S_1$,..., $S_n$) d'un autre circuit secondaire ne soit fermé pour la dernière fois dans la séquence.

6. Procédé selon l'une des revendications précédentes, **caractérisé en ce que** dans la séquence ce sont les commutateurs de calage ($S_1$,..., $S_n$) des circuits secondaires, dont les bandes conductrices de calage HTS ($C_1$,..., $C_n$) sont couplées au moins fortement par induction aux autres bandes conductrices de calage HTS ($C_1$,..., $C_n$), qui sont d'abord fermés une dernière fois.

7. Procédé selon l'une des revendications précédentes, **caractérisé en ce que** les variations du courant électrique sont effectuées dans une pluralité de circuits primaires qui comprennent m > 1 bobines de charge différentes ($P_1$,..., $P_m$) qui sont couplées par induction aux bandes conductrices de calage HTS ($C_1$,..., $C_n$).

Fig. 1

Fig.2

Fig.3

EP 3 667 351 B1

| | Ph1 | Ph2 | Ph3 |
|---|---|---|---|

ii'  ΔI0  ΔI1

v'  ΔI0  ΔI1  ΔI2

t

Fig.4

Fig. 5

Fig. 6

Fig. 7

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 8965468 B2
- DE 102016225017 A1
- US 9671479 B2
- WO 2007004787 A2
- GB 2424284 A
- US 9810755 B2
- DE 102015218019 A1
- US 6014069 A


**In der Beschreibung aufgeführte Nicht-Patentliteratur**

- **Y. IWASA et al.** Persistent-mode high-temperature superconductor shim coils: A design concept and experimental results of a prototype Z1 high-temperature superconductor shim. *Appl. Phys. Lett.,* 2013, vol. 103, 052607
- **T.A. COOMBS et al.** Flux pumps for HTS coils. *MAGNETICS TECHNOLOGY INTERNATIONAL,* 2017, 44-49
- **J. GENG et al.** Mechanism of a high-Tc superconducting flux pump: Using alternating magnetic field to trigger flux flow. *APPLIED PHYSICS LETTERS,* 2015, vol. 107, 142601
- **S. LEE et al.** Persistent Current Mode Operation of A 2G HTS Coil With A Flux Pump. *IEEE TRANSACTIONS ON APPLIED SUPERCONDUCTIVITY,* Juni 2016, vol. 26 (4
- **C. W. BUMBY et al.** Through-Wall Excitation of a Magnet Coil by an External-Rotor HTS Flux Pump. *IEEE TRANSACTIONS ON APPLIED SUPERCONDUCTIVITY,* Juni 2016, vol. 26 (4
- **D. PARK et al.** HTS Shim Coils Energized by a Flux Pump for the MIT 1.3-GHz LTS/HTS NMR Magnet: Design, Construction, and Results of a Proof-of-Concept Prototype. *IEEE TRANSACTIONS ON APPLIED SUPERCONDUCTIVITY,* April 2018, vol. 28 (3